# EUROPEAN PATENT SPECIFICATION

(11) **EP 0 780 924 B1**
(45) Date of publication and mention of the grant of the patent: **11.10.2000**
(21) Application number: 96120250.4
(22) Date of filing: 17.12.1996
(51) Int. Cl.: H01R 4/64, H05K 9/00, H01R 9/05

(54) **Device for electromagnetic disturbances shielding of a single cable**
Abschirmvorrichtung zum Schutz gegen elektromagnetische Störungen eines Kabels
Dispositif de blindage contre les perturbations électromagnétiques d'un câble

(30) Priority: 22.12.1995 IT MI952729
(43) Date of publication of application: 25.06.1997
(73) Proprietor: Italtel s.p.a., 20154 Milano (IT)
(72) Inventor: Puiu, Adrian, 20152 Milan (IT)
(74) Representative: Giustini, Delio

(56) References cited:
- DE-A- 2 261 973
- DE-A- 3 131 274
- DE-U- 9 108 708
- US-A- 4 547 623

## Description

### Field of the Invention

The present invention relates to a device to establish an electric contact between the metallic shielding braid of a cable and the metallic mass of a cubicle inside of which electronic or telecommunication equipment are housed, in the penetration point of the cable through the wall of the cubicle.

In telecommunication systems it is important to guarantee a suitable drainage towards the mass of the disturbance currents which, due to inductive and/or capacitive phenomenons, induce on the external conductor or on the metallic shielding braid of cables abutting on said equipment housed inside of shielded metallic cubicles. For this reason it is important to establish a good electric contact between the metallic shielding braid of the cable and the metallic mass of the cubicle, in the penetration point through a metallic wall of the cubicle, or of the entrance of the cable into the shielded interior of the cubicle.

When one or more shielded electric cables for the transportation of electric power or data must abut inside a shielded cubicle containing equipment sensible to electromagnetic disturbances, although in the abutting point the metallic braid wrapping the conductors is electrically connected to the metallic mass of the cubicle, the portion of the shielded cable contained inside the cubicle may constitute a way of access for electromagnetic disturbances due to the currents circulating in the metallic shielding braid of the cable.

Therefore it is important to assure an efficient drainage towards the mass of these currents induced in the point where the cable penetrates into the shielded space of the cubicle.

### Background Art

A lot of technical solutions are known for the implementation of a suitable electric contact between the metallic shielding braid of a cable and the metallic mass of the cubicle in proximity of the input hole of the cable into the shielded space inside the cubicle. DE 22 61 973 A shows an example of such a shielding device. But, especially in the case of cables passing individually through the wall of a shielded cubicle the known contacting devices turn out to be quite complex and/or require a relatively long installation time.

### Objects of the Invention

Therefore there is the necessity and/or the utility to realize a contacting device between the metallic braid of a shielded cable passing through a hole of a metallic wall of a shielded cubicle, and this wall in the entry point of the cable into the internal space of the simplest implementation, and which must not comprise laborious clamping operations.

Moreover there is the need to implement a device which turns out to be associable to the above-mentioned metallic shielding braid, and therefore to one of the walls of the cubicle making it possible for the operator to totally act from outside of the cubicle.

This objective has been perfectly reached by the device subject of the present invention.

### Summary of the Invention

According to the present invention the device is set-up by at least two deformable metallic braid clamping bodies substantially shaped as a cylindric sector and preferably by the number of two; the sectors provide contact for the shielding braid of the cable passing through the hole of the wall and the wall itself of the cubicle.

Each sector (or halfbush) is set-up by a metallic body provided with alternating longitudinal partial cuts, conferring to each element, and therefore to the whole bush, a radial elasticity; each sector (or halfbush) is also provided with radial projections suitable to set-up a circular portion of support flange on the face (typically on the external one) of the metallic wall of the cubicle adjacent to the passage hole of the cable.

The top edges of the sectors (or of the two halfbushes) have a conical shape such to realize a trunkconical surface of the whole contact bush.

The opposed radial coupling faces of the different sectors (or of both halfbushes) are provided with a spacer relief in the proximity of their bottom end; the bottom end is placed inside the cubicle, in the other side of the drilled wall opposed to the top extremity (external to the cubicle) with said conical surface.

A coupling or cylindric metal crampling ring is previously inserted along the cable that has been passed through the hole and is forcedly pushed over the external extremities of the sectors (or of both halfbushes).

The cylindric metal clamping ring is provided with an internal trunkconical surface suitable to press against the trunkconical edge of the contact bush, pushing inside the edges of the sectors (or of both halfbushes) and forcing contact on the metallic shielding braid of the cable.

The internal cylindric face of the metal ring is provided with longitudinal ribs extending over it's bottom edge; the bottom edge gets inserted in the separation space between the opposed radial coupling faces, (spaced by said reliefs), of the sectors (or both halfbushes), setting up the contact bush.

Contemporaneously to the inside-press action carried out by the trunkconical internal surfaces of the metal ring on the conic extremities of the sectors or both halfbushes, the ribs (or longitudinal noses) extend over the bottom edge of the bush, interfering with the relief present on the radial coupling faces of the sectors (or both halfbushes); the opposed bottom extremities of the sectors, are in this way pressed against the metallic wall of the passage hole of the cable (outside-press action). Suitable reliefs or radial teeth (which may be present on the extremities of the sectors or divaricated halfbushes) are pressed under the edge of the passage hole, preventing the tearing of the contact and fixing the cable.

In this way the assemblage is completed simply by pushing the metal ring (already put on the cable) over the bush set-up by two or more sectors.

The metal clamping ring (or sleeve) is provided with a longitudinal cut, suitable to give radial elasticity to the ring.

### Brief Description of the Drawings

The features of the present invention are set forth with particularity in the appended claims. The invention, together with further objects and advantages thereof, may be understood with reference to the following description, taken in conjunction with the accompanying drawings and in which:
Figures 1, 2, 3 show the installation steps of the contact and anchorage device according to the invention for the cable;
Figure 4 is a partial cross section view of the metal clamping ring;
Figure 5 is a view of a contact halfbush.

### Detailed Description of a Preferred Embodiment of Realization

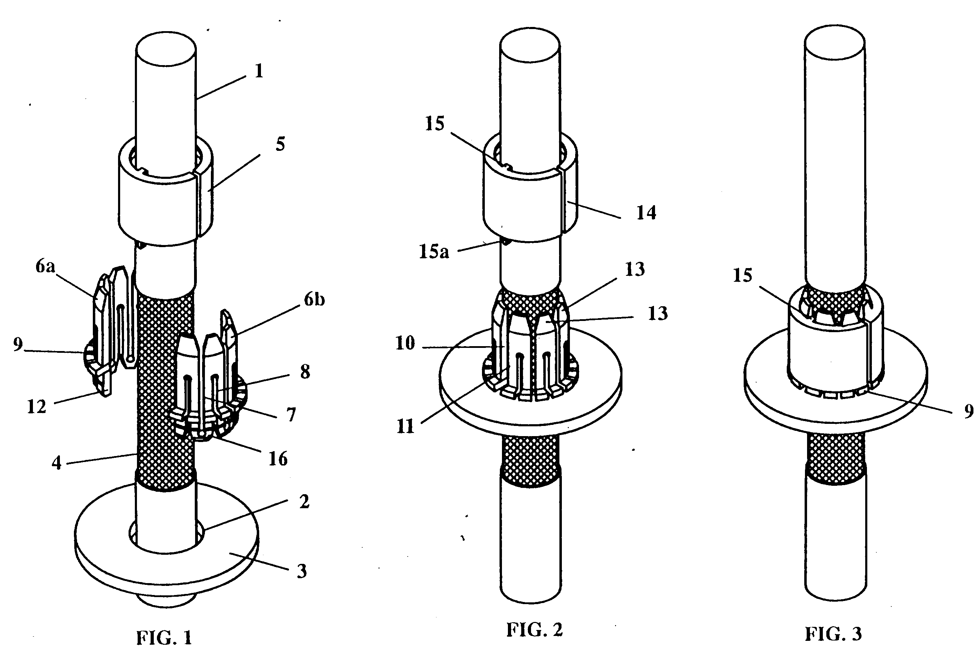

Figures 1, 2, 3 show the installation steps of the contact and anchorage device for a shielded cable 1 passing through an input hole 2 of a metallic wall 3 of a shielded cubicle or room inside of which equipment may be housed being sensible to electromagnetic disturbances.

As shown, the shielded cable 1 must be free of the isolating sheathing the passage part through the hole 2 in order to uncover the metallic shielding braid 4. Before passing the cable through the hole 2 it is necessary to put the blocking sleeve or metal ring 5 on the cable.

The cable is therefore positioned and two metallic halfbushes, 6a and 6b, respectively, are put into the same hole 2 of the metallic wall 3 of the cubicle.

Each one of the metallic contact halfbushes may be realized by starting from a metal section (which may be incised by shearing and then cut and- shaped like a halfbush) or by mechanical toding. The material used for the two halfbushes 6a and 6b may be copper, nickelled copper, stainless steel or other suitable metallic material.

The two halfbushes 6a and 6b are essentially provided with longitudinal alternating cuts 7 and 8 suitable to give radial elasticity (by stressing the "particularities" of the link between the subsectors in which each halfbush turns out to be subdivided) and of radial projections 9 suitable to set-up circular portions of a support flange on the face of the wall 3, adjacent to the passage hole 2, as shown in Fig. 2.

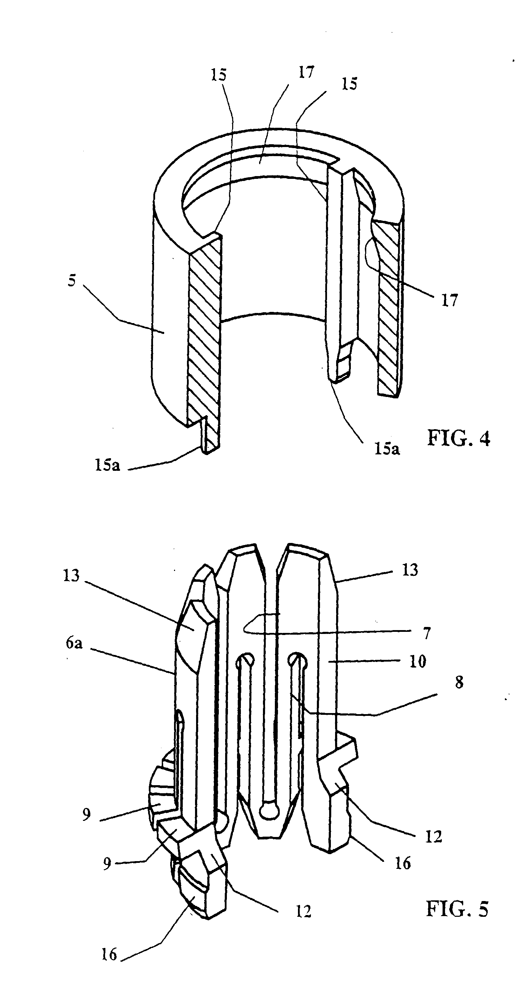

The radial "coupling" faces 10 and 11 are provided (in correspondence of the passage area of the extremities of the bushes put through hole 2) with spacer reliefs 12 (see also Fig. 5) suitable to maintain a certain distance between the opposed radial faces 10 and 11 of both halfbushes, when these are put inside the hole 2 around the cable 1.

Moreover the top ends of the halfbushes are provided with a conic surface 13 in order to set-up an essentially trunkconical extremity of the bush composed by the two sectors (halfbushes) 6a and 6b.

The blocking sleeve or metal ring 5 (which may be made of metallic material similar to the one used to make the halfbushes 6a and 6b, or also of different material) is preferably provided with a longitudinal cut 14 suitable to give it a radial elasticity. The metal clamping ring is moreover provided with internal longitudinal ribs 15 (in the same number of the sectors 6a and 6b which set-up the cylindric contact bush), two in the illustrated case.

These internal longitudinal ribs extend over the bottom edge of the blocking metal ring, setting up snugs or extensions 15a as shown in the Figures 1, 2 and the following Fig. 5.

During the assemblage phase, the snugs 15a and the corresponding longitudinal ribs 15, are sliding between the opposed radial coupling faces of the different sectors 6a and 6b, setting up the contact bush, (which are maintained at a distance by the reliefs 12).

The clamping metal ring 5 is pushed over the contact bush, until it's shoulder touches the radial projections 9.

By this, the internal trunkconical surface 17 (see Fig. 4) of the clamping ring 5 abuts and interferes with the conical external surfaces 13 of the halfbushes 6a and 6b, pushing them inside and against the metallic braid 4 of the shielded cable (in order to realize a good electric contact with this one). Contemporaneously, the snugs 15a interfering with the spacer reliefs 12 (on the radial coupling faces of the halfbushes 6a and 6b) divaricate the bottom part of the halfbushes 6a and 6b, pushing the extremities against the walls of the hole (establishing therefore a contact with the metallic mass of the wall 3 of the cubicle).

By pushing-apart the bottom extremities of the sectors (or halfbushes) 6a and 6b, those ones (on purpose provided with an anchorage relief or tooth 16) set-up an efficient anchorage under the internal edge of the hole 2 (opposing in an efficient way a snatching of the cable from the mechanical contact) and blocking seat ( set-up in this way in the passage point of the cable through the wall 3).

Fig. 4 is an axonometric view, partially in cross section, of the clamping metal ring 5, where it is possible to see the internal trunkconial surface 17, suitable to abut on the conical surfaces 13 of the halfbushes pushing the respective extremities against the metallic braid of the shielded cable, as well as the shape of the internal longitudinal ribs 15, extended over the bottom edge of the metal ring, in order to set-up snugs (or extensions) 15a.

Fig. 5 is a magnified view of one contact sector or halfbush 6a where it is easier to identify the already described particularities.

While a particular embodiment of the present invention has been shown and described, it should be understood that the present invention is not limited thereto since other embodiments may be made by those skilled in the art. It is thus contemplated that the present invention encompasses any and all such embodiments covered by the following claims.

One of such variations may be, for instance, inherent to the presence of release stop means (not shown) of the blocking metal ring 5, against said halfbushes 6a and 6b, for example under the form of projections foreseen on said longitudinal ribs that enter seats provided for on the opposite faces 10 and 11 of said two halfbushes 6a and 6b.

## Claims

1. Shielding device suitable to prevent disturbances of the electromagnetic type of a single cable abutted at electronic or telecommunication equipment housed inside a metallic cubicle, and suitable to make an electric contact between the metallic braid (4) of the shielded cable passing through a hole (2) made in one of the walls of the above-mentioned cubicle and the metallic mass (3) of the cubicle, substantially at the input point of the cable into the internal shielded space, including :
at least two deformable elastic metallic braid-clamping bodies (6a, 6b), substantially shaped as cylindric sectors, suitable to set-up a contact bush with the shielding braid (4) of the cable passing through said hole (2);
each one of said sectors being provided with longitudinal partial cuts (7, 8), suitable to give a certain radial elasticity, and with radial projections (9) suitable to set-up a circular support flange portion on the face of the cubicle wall adjacent to the hole (2) for the passage of the cable;
at least the extremity of said sectors (6a, 6b), extending from the same side of the face of said perforated wall on which said flange can be put, having a conical surface (13) such as to form a trunkconical end of the bush set-up by said sectors;
the opposed radial coupling faces of said braid-clamping sectors being provided with a spacer relief, in proximity of the end opposed to said trunkconical end, which extends from the other side of the perforated wall;
a cylindric metal clamping ring (5), that can be put previously on the cable passed through said hole, having an internal trunkconical surface (17) suitable to press inside against said conical top ends, clamping them to forced contact on said braid, and a number of internal longitudinal ribs, extending over the edge of the metal ring, suitable to slide between said opposed radial coupling faces of said sectors and to push-apart said opposed bottom ends of the sectors, with forced contact with the wall (3) of the hole (2) interfering with said spacer reliefs (12).

2. Device according to claim 1, characterized in that in correspondence to said opposed ends, said sectors (6a, 6b) are provided with radial teeth (16) that get fixed under the edge of the hole (2) of the wall (3) after said push-apart action.

3. Device according to claim 1, characterized in that it comprises also restraining means of said cylindric clamping ring (5) on said at least two metallic braid clamping bodies (6a, 6b).

4. Device according to claim,3, characterized in that said restraining means are shaped as extensions provided for on said longitudinal ribs (15a) of the cylindric braid (5) which enter seats provided for on the opposed faces (10 and 11) of said at least two metallic braid clamping bodies (6a, 6b).

5. Device according to claim 1, characterized in that said cylindric braid clamping ring (5) is provided with a slit.

6. Device according to claim 1, characterized in that said longitudinal partial cuts (7, 8) provided for on said at least two metallic braid clamping bodies are alternated.

## Patentansprüche

1. Abschirmungseinrichtung, die dafür geeignet ist, Störungen des elektromagnetischen Typs an einem einzelnen Kabel zu verhindern, das an elektronisches oder Telekommunikationsgerät anstößt, das in einem metallischen Schaltschrank untergebracht ist, und die sich dafür eignet, zwischen der metallischen Litze (4) des abgeschirmten Kabels, das durch ein Loch (2) in einer der Wände des obenerwähnten Schaltschranks geht, und der metallischen Masse (3) des Schaltschranks im wesentlichen am Eingangspunkt des Kabels in den inneren abgeschirmten Raum einen elektrischen Kontakt herzustellen, mit:
mindestens zwei verformbaren elastischen metallischen Litzenklemmkörpern (6a, 6b), die im wesentlichen als zylindrische Sektoren ausgebildet sind, die dafür geeignet sind, mit der Abschirmungslitze (4) des durch das Loch (2) gehenden Kabels eine Kontaktbuchse zu bilden;
wobei jeder einzelne der Sektoren mit Längsteilschnitten (7, 8) versehen ist, die sich dafür eignen, eine gewisse radiale Elastizität zu verleihen, und mit radialen Vorsprüngen (9), die sich dafür eignen, einen kreisförmigen Stützflanschteil an der Fläche der Schaltschrankwand neben dem Loch (2) für den Durchtritt des Kabels zu bilden;
wobei mindestens der Endpunkt der Sektoren (6a, 6b), der sich von der gleichen Seite der Fläche der durchlöcherten Wand erstreckt, auf der der Flansch angeordnet werden kann, eine konische Oberfläche (13) aufweist, um ein kegelstumpfförmiges Ende der durch die Sektoren gebildeten Buchse zu bilden;
wobei die gegenüberliegenden radialen Kopplungsflächen der Litzenklemmsektoren in der Nähe des dem kegelstumpfförmigen Ende gegenüberliegenden Endes, das sich von der anderen Seite der durchlöcherten Wand aus erstreckt, mit einer Abstandshaltererhöhung versehen sind;
wobei ein zylindrischer Metallklemmring (5), der zuvor auf das durch das Loch gehende Kabel gesetzt werden kann, eine innere kegelstumpfförmige Oberfläche (17) aufweist, die sich dafür eignet, innen gegen die konischen oberen Enden zu drücken, wodurch sie im erzwungenen Kontakt an der Litze geklemmt werden, und eine Reihe innerer Längsrippen, die sich über die Kante des Metallrings erstrecken, die sich dafür eignen, zwischen die gegenüberliegenden radialen Kopplungsflächen der Sektoren zu gleiten und die gegenüberliegenden unteren Enden der Sektoren auseinanderzudrücken, wobei ein erzwungener Kontakt mit der Wand (3) des Lochs (2) mit den Abstandshaltererhöhungen (12) interferiert.

2. Einrichtung nach Anspruch 1, dadurch gekennzeichnet, daß in Entsprechung mit den gegenüberliegenden Enden die Sektoren (6a, 6b) mit radialen Zähnen (16) versehen sind, die unter der Kante des Lochs (2) der Wand (3) nach der Auseinanderdrückaktion fixiert werden.

3. Einrichtung nach Anspruch 1, dadurch gekennzeichnet, daß sie auch Zurückhaltemittel des zylindrischen Klemmrings (5) auf den mindestens zwei metallischen Litzenklemmkörpern (6a, 6b) umfaßt.

4. Einrichtung nach Anspruch 3, dadurch gekennzeichnet, daß die Zurückhaltemittel als Verlängerungen ausgebildet sind, die an den Längsrippen (15a) der zylindrischen Litze (5) vorgesehen sind, die in Sitze eintreten, die an den gegenüberliegenden Flächen (10 und 11) der mindestens zwei metallischen Litzenklemmkörper (6a, 6b) vorgesehen sind.

5. Einrichtung nach Anspruch 1, dadurch gekennzeichnet, daß der zylindrische Litzenklemmring (5) mit einem Schlitz versehen ist.

6. Einrichtung nach Anspruch 1, dadurch gekennzeichnet, daß die an den mindestens zwei metallischen Litzenklemmkörpern vorgesehenen Längsteilschnitte (7, 8) alternieren.

## Revendications

1. Dispositif de blindage convenant pour empêcher des perturbations de type électromagnétique d'un câble unique aboutissant à un équipement électronique ou de télécommunications logé à l'intérieur d'une armoire métallique, et convenant pour établir un contact électrique entre la tresse métallique (4) du câble blindé passant à travers un trou (2) pratiqué dans une des parois de l'armoire susmentionnée et la masse métallique (3) de l'armoire, substantiellement à l'endroit d'entrée du câble dans l'espace blindé interne, comportant :
au moins deux corps de serrage de tresse métallique élastiques déformables (6a, 6b), substantiellement conformés en secteurs cylindriques, convenant pour constituer une douille de contact avec la tresse de blindage (4) du câble passant à travers ledit trou (2) ;
chacun desdits secteurs étant muni de découpes partielles longitudinales (7, 8), convenant pour conférer une certaine élasticité radiale, et de saillies radiales (9) convenant pour constituer une partie de bride de support circulaire sur la face de la paroi d'armoire adjacente au trou (2) pour le passage du câble :
au moins l'extrémité desdits secteurs (6a, 6b), s'étendant à partir du même côté de la face de ladite paroi perforée sur laquelle ladite bride peut être mise, ayant une surface conique (13) de manière à former une extrémité tronconique de la douille constituée par lesdits secteurs ;
les faces d'accouplement radiales opposées desdits secteurs de serrage de bride étant munies d'un relief d'écartement, à proximité de l'extrémité opposée à ladite extrémité tronconique, qui s'étend depuis l'autre côté de la paroi perforée ;
un anneau de serrage métallique cylindrique (5), qui peut être posé préalablement sur le câble passé à travers ledit trou, ayant une surface tronconique interne (17) convenant pour presser vers l'intérieur contre lesdites extrémités supérieures coniques, les fixant en un contact forcé sur ladite tresse, et un certain nombre de nervures longitudinales internes, s'étendant par-dessus le bord de l'anneau métallique, convenant pour coulisser entre lesdites faces d'accouplement radiales opposées desdits secteurs et pour écarter lesdites extrémités inférieures opposées desdits secteurs, le contact forcé avec la paroi (3) du trou (2) interférant avec lesdits reliefs d'écartement (12).

2. Dispositif selon la revendication 1, caractérisé en ce qu'en correspondance avec lesdites extrémités opposées, lesdits secteurs (6a, 6b) sont munis de dents radiales (16) qui viennent se fixer sous le bord du trou (2) de la paroi (3) après ladite action d'écartement.

3. Dispositif selon la revendication 1, caractérisé en ce qu'il comprend aussi des moyens de restriction dudit anneau de serrage cylindrique (5) sur lesdits au moins deux corps de serrage de tresse métallique (6a, 6b).

4. Dispositif selon la revendication 3, caractérisé en ce lesdits moyens de restriction sont conformés sous forme d'extensions prévues sur lesdites nervures longitudinales (15a) de la tresse cylindrique (5) qui entrent dans des sièges prévus sur les faces opposées (10 et 11) desdits au moins deux corps de serrage de tresse métallique (6a, 6b).

5. Dispositif selon la revendication 1, caractérisé en ce que ledit anneau de serrage de tresse cylindrique (5) est muni d'une fente.

6. Dispositif selon la revendication 1, caractérisé en ce lesdites découpes partielles longitudinales (7, 8) pratiquées sur lesdits au moins deux corps de serrage de tresse métallique sont alternées.
